# EUROPEAN PATENT APPLICATION

(11) **EP 4 598 314 A1**
(43) Date of publication of application: **06.08.2025**
(21) Application number: 23871738.3
(22) Date of filing: 01.09.2023
(51) Int. Cl.: H10K 30/50, H10K 30/40, H10K 30/81, H10K 30/88, H10K 30/89

(54) **SOLAR CELL MODULE AND METHOD FOR MANUFACTURING SOLAR CELL MODULE**

(30) Priority: 30.09.2022 JP 2022158254
(71) Applicant: Panasonic Holdings Corporation, Osaka, 571-8501 (JP)
(72) Inventor: NAKAMURA, Yuya, Kadoma-shi, Osaka 571-0057 (JP)
(74) Representative: Grünecker Patent- und Rechtsanwälte PartG mbB
(86) International application number: PCT/JP2023/032073
(87) International publication number: WO 2024/070498

(57) **Abstract**

A solar cell module (1) according to an example of an embodiment comprises a substrate (2), a first electrode layer (11) provided to the substrate (2), a photoelectric conversion layer (10) provided to the first electrode layer (11), a second electrode layer (12) provided to the photoelectric conversion layer (10), an extraction electrode layer (20), and a sealing layer (30). The sealing layer (30) has an opening (30A) in a region that corresponds to the extraction electrode layer (20). When the substrate (2) is viewed in plan view from the surface where the photoelectric conversion layer (10) is provided, the extraction electrode layer (20) is exposed from the opening (30A) and the sealing part (30) covers the peripheral edge part of the extraction electrode layer (20).

## Description

### TECHNICAL FIELD

The present disclosure relates to a solar cell module and a manufacturing method thereof, and more particularly to a solar cell module having a photoelectric conversion layer formed on an insulating substrate such as a glass substrate, and a manufacturing method thereof.

### BACKGROUND ART

Conventionally, there have been known solar cell modules having a photoelectric conversion layer formed on an insulating substrate such as a glass substrate. Patent Literature 1 discloses a solar cell module comprising a substrate, a plurality of solar cells formed on the substrate, an extraction electrode formed on the substrate for extracting electric charges from the solar cells, an extraction wiring member for collecting electric charges from the extraction electrode, a covering material that covers the extraction wiring member, and a sealing material.

Further, Patent Literature 2 discloses a solar cell including a cathode, an anode, a photoelectric conversion layer provided between the cathode and the anode, and a resin layer provided on either the cathode or the anode. Patent Literature 2 describes that the photoelectric conversion layer contains an organic-inorganic perovskite compound represented by general formula R-M-X₃ (where R is an organic molecule, M is a metal atom, and X is a halogen atom or a chalcogen atom.

### CITATION LIST

### PATENT LITERATURE

PATENT LITERATURE 1: Japanese Unexamined Patent Application Publication No. 2009-188211
PATENT LITERATURE 2: Japanese Unexamined Patent Application Publication No. 2016-174151

### SUMMARY

The output performance of a photoelectric conversion layer of a solar cell significantly degrades in the presence of water vapor, oxygen, and light, so that, as described in Patent Literature 1 and 2, the photoelectric conversion layer is sealed to prevent water vapor and oxygen from acting on the photoelectric conversion layer. In particular, when the photoelectric conversion layer is a perovskite element, the decrease in output due to the influence of water vapor and oxygen is significant. Further, as described in Patent Literature 1, an electrode for extracting electric power generated by solar cells to the outside is provided in a solar cell module, and the sealing performance around the electrode is more likely to deteriorate than in other parts. It is therefore expected that water vapor and oxygen would flow in from around the electrode.

An object of the present disclosure is to provide a solar cell module which is capable of sufficiently suppressing inflow of water vapor and oxygen into the module and which has excellent sealing performance.

A solar cell module according to the present disclosure includes: a substrate; a first electrode layer provided on the substrate; a photoelectric conversion layer provided on the first electrode layer; a second electrode layer provided on the photoelectric conversion layer; an extraction electrode layer provided on the substrate in a region that does not overlap with the photoelectric conversion layer when the substrate is observed in plan view; and a sealing layer which is provided so as to cover the first electrode layer, the photoelectric conversion layer, the second electrode layer, and the extraction electrode layer, and which has an opening in a region corresponding to the extraction electrode layer. When the substrate is observed in plan view from a side on which the photoelectric conversion layer is provided, the extraction electrode layer is exposed through the opening, and a peripheral portion of the extraction electrode layer is covered by the sealing layer.

According to the solar cell module according to the present disclosure, inflow of water vapor and oxygen into the module can be sufficiently suppressed. The solar cell module according to the present disclosure has excellent sealing performance, and therefore, for example, can maintain good output performance for a long period of time.

### BRIEF DESCRIPTION OF DRAWINGS

FIG. 1 is a cross-sectional view of a solar cell module according to a first embodiment.
FIG. 2 is a cross-sectional view of a solar cell module according to a second embodiment.
FIG. 3 is a cross-sectional view of a solar cell module according to a third embodiment.
FIG. 4 is a diagram for explaining an example method for manufacturing the solar cell module according to the first embodiment.
FIG. 5 is a diagram for explaining an example method for manufacturing the solar cell module according to the second embodiment.
FIG. 6 is a diagram for explaining an example method for manufacturing the solar cell module according to the third embodiment.
FIG. 7 is a cross-sectional view of a solar cell module according to a fourth embodiment.
FIG. 8 is a cross-sectional view of a solar cell module according to a fifth embodiment.
FIG. 9 is a cross-sectional view of a solar cell module according to a sixth embodiment.
FIG. 10 is a cross-sectional view of a solar cell module according to a seventh embodiment.

### DESCRIPTION OF EMBODIMENTS

Example embodiments of a solar cell module according to the present disclosure will now be described in detail by reference to the drawings. Configurations formed by selectively combining the constituent elements of a plurality of embodiments and variants described below are included within the scope of the present disclosure.

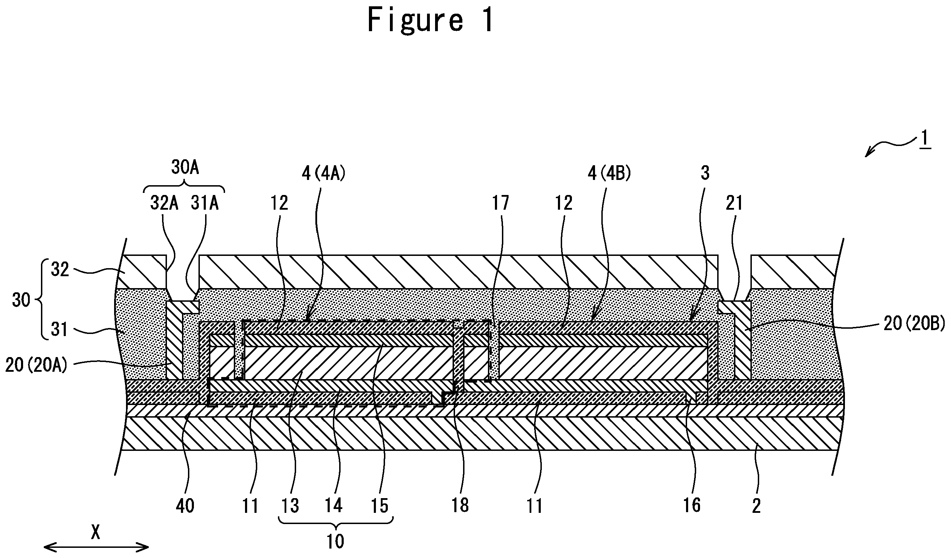

FIG. 1 schematically illustrates the structure of a cross section obtained when a solar cell module 1 according to the first embodiment is cut in the X direction. Here, a first direction along the surface of a substrate 2 is referred to as the "X direction (shown in FIG. 1)", and a second direction along the surface of the substrate 2 and orthogonal to the X direction is referred to as the "Y direction (i.e., the direction orthogonal to the surface of the paper sheet showing FIG. 1)". As shown in FIG. 1, the solar cell module 1 comprises a substrate 2, and a cell 3 provided on the substrate 2. The cell 3 is composed of a plurality of unit cells 4 connected in series. Each unit cell 4 includes a photoelectric conversion layer 10, a first electrode layer 11, and a second electrode layer 12.

The solar cell module 1 further includes an extraction electrode layer 20 and a sealing layer 30. The extraction electrode layer 20 is an electrode for extracting electric energy from the cell 3 to the outside of the module, and is provided in a region that does not overlap with the photoelectric conversion layer 10 when the substrate 2 is observed in plan view. The sealing layer 30 is a layer that, together with the substrate 2, sandwiches the cell 3 and serves to prevent water vapor and oxygen from flowing into the module. The sealing layer 30 is provided so as to cover the cell 3 (i.e., the photoelectric conversion layer 10, the first electrode layer 11, and the second electrode layer 12) and the extraction electrode layer 20, and has an opening 30A in a region corresponding to the extraction electrode layer 20.

The solar cell module 1 may include an inorganic film 40 provided on the substrate 2. The inorganic film 40 is interposed between the substrate 2 and the first electrode layer 11. As the inorganic film 40, for example, the same type of inorganic film as the barrier layer of a second layer 32 described further below may be used.

As will be described later in detail, in the solar cell module 1, when the substrate 2 is observed in plan view from the side on which the photoelectric conversion layer 10 is provided, the extraction electrode layer 20 is exposed through the opening 30A in the sealing layer 30, and the peripheral portion of the extraction electrode layer 20 is covered by the sealing layer 30. That is, a surface 21 of the extraction electrode layer 20 facing away from the substrate 2 is partially exposed through the opening 30A of the sealing layer 30, and the part around the exposed portion is covered by the sealing layer 30. With this feature, inflow of water vapor and oxygen into the module from around the extracting electrode layer 20 is effectively suppressed.

As the substrate 2, a conductive substrate having an insulating layer formed on its surface may be used, but an insulating substrate is preferably used. The substrate 2 is, for example, composed of a material which is transparent to sunlight with a wavelength greater than or equal to 400 nm and less than or equal to 1000 nm, and which has low water vapor permeability. The substrate 2 may be a substrate made of resin or a substrate made of glass. The thickness of the substrate 2 is, for example, greater than or equal to 0.02 mm and less than or equal to 3 mm. Since the solar cell module 1 includes a support member 5, it is also possible to use, as the substrate 2, a resin film similar to the barrier film described further below.

As noted above, the solar cell module 1 includes a plurality of unit cells 4 connected in series. The unit cells 4 are arranged in a plural number in the X direction, and each unit cell 4 extends continuously in the Y direction orthogonal to the X direction. Each unit cell 4 of the present embodiment is a perovskite-type cell, and includes the first electrode layer 11 provided on the substrate 2, the photoelectric conversion layer 10 provided on the first electrode layer 11, and the second electrode layer 12 provided on the photoelectric conversion layer 10. Here, at least one of the substrate 2 and the sealing layer 30 which cover the surfaces of the cell 3 (i.e., each of the unit cells 4) has optical transparency. With this feature, light enters the module from the substrate 2 side, the sealing layer 30 side, or both sides, and is absorbed by the photoelectric conversion layer 10 in each unit cell 4. In the present embodiment, the sealing layer 30 is opaque, and the surface of the substrate 2 serves as the light-receiving surface of the module.

The photoelectric conversion layer 10 includes a light-absorbing layer 13, an electron transport layer 14, and a hole transport layer 15, and has a layered structure in which the electron transport layer 14 and the hole transport layer 15 are arranged to sandwich the light-absorbing layer 13 from respective sides. In the photoelectric conversion layer 10 of the present embodiment, in parts other than where a groove to be described later is formed, the electron transport layer 14, the light-absorbing layer 13, and the hole transport layer 15 are provided in this order from the substrate 2 side. The light-absorbing layer 22 contains, for example, a perovskite compound represented by composition formula ABX₃ (where A is a monovalent cation, B is a divalent cation, and X is a halogen anion).

The electron transport layer 14 is composed of an n-type semiconductor, and is also referred to as an n-layer. Examples of an electron transport material constituting the electron transport layer 14 include anatase titanium oxide and tin oxide. The hole transport layer 15 is composed of a p-type semiconductor, and is also referred to as a player. The hole transport layer 15 contains a hole transport material with a redox site. Examples of the hole transport material constituting the hole transport layer 15 include, among others, 2,2',7,7'-tetrakis(N,N'-di-p-methoxyphenylamino)-9,9'-spirobifluorene (Spiro-OMeTAD).

An example of A in the above-noted perovskite compound (ABX₃) is a monovalent cation represented by R₁R₂R₃-N-H. When R₁ and R₂ are H and R₃ is CH₃, A is methylammonium (CH₃NH₃). The functional groups R₁, R₂, and R₃ each contain, for example, at least one element selected from carbon, hydrogen, nitrogen, and oxygen. When the functional groups R₁, R₂, and R₃ contain carbon atoms, the total number of carbon atoms in the functional groups R₁, R₂, and R₃ is preferably less than or equal to 4. The functional groups R₁, R₂, and R₃ may contain a Group 1 element such as Rb or Cs.

As noted above, B in ABX₃ is a divalent cation. B is, for example, a divalent cation of a transition metal or a Group 13, 14, or 15 element. Specific examples of B include Pb²⁺, Ge²⁺, and Sn²⁺. B may contain at least one selected from Pb²⁺ and Sn²⁺, and Pb²⁺ and Sn²⁺ may be partially substituted with other elements. Examples of the substituting element include Bi, Sb, In, Ge, and Ni. X in ABX₃ is at least one selected from Cl, Br, and I.

Each of the above A, M, and X sites may be occupied by a plurality of types of ions. Specific examples of the perovskite compound (ABX₃) include CH₃NH₃PbI₃, CH₃CH₂NH₃PbI₃, NH₂CHNH₂PbI₃, CH₃NH₃PbBr₃, CH₃NH₃PbCl₃, CsPbI₃, and CsPbBr₃. The light-absorbing layer 13 composed of CH₃NH₃PbI₃ is also referred to as a PVSK element.

The first electrode layer 11 and the second electrode layer 12 have optical transparency, and preferably do not block entry of light into the photoelectric conversion layer 10. The light transmittance of each of the electrode layers is, for example, greater than or equal to 85% in the wavelength range from 450 nm to 900 nm. Further, the sheet resistance of each electrode layer is preferably less than or equal to 200 Ω/□, and may be less than or equal to 50 Ω/□. An example of a suitable electrode layer is a transparent conductive layer composed of a transparent conductive oxide, such as indium tin oxide (ITO), which is obtained by doping a metal oxide such as indium oxide or zinc oxide with tungsten, tin, antimony, or the like. The thickness of the transparent conductive layer is, for example, greater than or equal to 30 nm and less than or equal to 300 nm. Each electrode layer can be formed by a conventionally known method such as sputtering.

In FIG. 1, two unit cells 4 located adjacent to each other in the X direction are shown, with the left unit cell 4 being referred to as "unit cell 4A" and the right unit cell 4 being referred to as "unit cell 4B". The number of unit cells 4 to be included in the solar cell module 1 is not particularly limited, and may be greater than or equal to 3. In the example shown in FIG. 1, the second electrode layer 12 of the unit cell 4A is electrically connected to the first electrode layer 11 of the unit cell 4B. When three or more unit cells 4 are included, for example, the second electrode layer 12 of the unit cell 4B is electrically connected to the first electrode layer 11 of a third unit cell 4 located adjacent thereto in the X direction. In this manner, a plurality of unit cells 4 are connected in series along the X direction.

The cell 3 has grooves 16, 17, 18 formed therein. The grooves 16, 17, 18 are formed by removing parts of the layers constituting the cell 3, and are formed to extend in the Y direction and substantially parallel to each other. Each of the grooves can be formed by a conventionally known scribing method or the like. The width of each groove is, for example, greater than or equal to 30 µm and less than or equal to 300 µm. The groove 17 is filled with a resin that constitutes the sealing layer 30 so that no void is created inside the groove.

The groove 16 is a groove that divides the first electrode layers 11 of the respective unit cells 4. The groove 17 divides the light-absorbing layers 13, the hole transport layers 15, and the second electrode layers 12 of the respective unit cells 4. Here, the groove 17 only needs to divide the second electrode layers 12 of the unit cells 4, and it may be the case that the light-absorbing layers 13 and the hole transport layers 15 are not divided by the groove 17. In the present embodiment, the unit cells 4 are partitioned by the grooves 16, 17.

The groove 18 is formed so as to cut through the hole transport layer 15, the light-absorbing layer 13, and the electron transport layer 14 and to expose the first electrode layer 11 of the unit cell 4B. Furthermore, the second electrode layer 12 of the unit cell 4A is formed inside the groove 18. With this feature, the first electrode layer 11 of the unit cell 4B is electrically connected to the second electrode layer 12 of the unit cell 4A. That is, the groove 18 functions as a conductive path that connects a plurality of unit cells 4 in series.

The cell 3 is manufactured, for example, by the following method.
(1) On the substrate 2, the first electrode layer 11 and the electron transport layer 14 are formed in this order.
(2) A part of the first electrode layer 11 is subjected to a laser scribing process to form the groove 16.
(3) On the electron transport layer 14, the light-absorbing layer 13 and the hole transport layer 15 are formed in this order.
(4) A part of each of the hole transport layer 15, the light-absorbing layer 13, and the electron transport layer 14 is subjected to a mechanical scribing process to form the groove 18.
(5) On the hole transport layer 15, the second electrode layer 12 is formed. At that time, the second electrode layer 12 is formed inside the groove 18, and the above-noted conductive path is thereby formed.
(6) A part of each of the second electrode layer 12, the hole transport layer 15, and the light-absorbing layer 13 is subjected to a mechanical scribing process to form the groove 17.

Each of the light-absorbing layer 13, the electron transport layer 14, and the hole transport layer 15 can be formed, for example, by coating the surface of the substrate 2 with a solution prepared by dissolving therein constituent materials of the layer. These layers may be formed by meniscus coating, spin coating, or by using a dispenser. The thickness of each of the layers is not particularly limited, and is, in one example, greater than or equal to 10 nm and less than or equal to 500 nm.

The configuration of the extraction electrode layer 20 and the sealing layer 30 will now be described in detail.

The extraction electrode layer 20 has a structure formed by depositing a metal layer, and is provided on the substrate 2 in a region that does not overlap with the photoelectric conversion layer 10 when the substrate 2 is observed in plan view. In other words, the extraction electrode layer 20 is provided in a region that does not overlap with the photoelectric conversion layer 10 in the thickness direction of the solar cell module 1. The extraction electrode layer 20 includes an extraction electrode layer 20A electrically connected to the first electrode layer 11 of the unit cell 4A, and an extraction electrode layer 20B electrically connected to the second electrode layer 12 of the unit cell 4B. The extraction electrode layer 20A is located at a first end in the X direction of the substrate 2, and the extraction electrode layer 20B is located at a second end opposite to the first end in the X direction.

The metal layer constituting the extraction electrode layer 20 is composed of, for example, a metal such as aluminum, nickel, copper, or silver, or an alloy of such a metal. Among these, silver is preferably used. The metal layer may have a single-layer structure, or may have a multi-layer structure including layers of different metals. An example thickness of the extraction electrode layer 20 is greater than or equal to 10 µm and less than or equal to 100 µm. The extraction electrode layer 20 may be formed by printing, sputtering, vapor deposition, or the like, or may be formed by a plating method.

The sealing layer 30 is a layer that covers the entire cell 3, and serves to prevent water vapor and oxygen from flowing into the module. The sealing layer 30 may also have a function of trapping water vapor and the like. The sealing layer 30 covers the side surfaces of the extraction electrode layer 20 along the thickness direction. Meanwhile, since the extraction electrode layer 20 is an electrode for extracting power generated in the cell 3 to the outside of the module, a part of the surface 21 of the extraction electrode layer 20 facing away from the substrate 2 is not covered by the sealing layer 30 and is exposed. The sealing layer 30 has formed therein the opening 30A through which the part of the surface 21 of the extraction electrode layer 20 is exposed.

The sealing layer 30 covers the peripheral portion of the surface 21 of the extraction electrode layer 20 when the substrate 2 is observed in plan view from the side on which the photoelectric conversion layer 10 is provided. No particular limitation is imposed on the shape of the opening 30A of the sealing layer 30, and one example of the shape is a circular shape in plan view. The opening 30A of the sealing layer 30 is positioned so as to overlap the surface 21 of the extraction electrode layer 20 in the thickness direction of the module, and the part having the smallest opening area is smaller than the surface 21. In the present embodiment, the area of the opening 30A is smallest at the part in contact with the surface 21.

The sealing layer 30 may have a single-layer structure or a multi-layer structure having three or more layers, but in the present embodiment, the sealing layer 30 has a two-layer structure including a first layer 31 and a second layer 32. The first layer 31 has a first opening 31A in a region corresponding to the extraction electrode layer 20. The second layer 32 is provided so as to cover the first layer 31, and has a second opening 32A in a region corresponding to the extraction electrode layer 20. As will be described later in detail, the first opening 31A and the second opening 32A are arranged to overlap in the thickness direction of the module, and form the opening 30A of the sealing layer 30.

The first layer 31 is filled inside the groove 17 formed in the cell 3, between the cell 3 and the extraction electrode layer 20, and the like, and is closely adhered to the cell 3 and the extraction electrode layer 20. The first layer 31 is preferably adhered to the cell 3 without any gaps so that no void is created between the first layer 31 and the cell 3. In that case, inflow of water vapor and oxygen into the module is suppressed. The first layer 31 is preferably composed of a resin having low permeability to water vapor and oxygen. The first layer 31 may contain a moisture-absorbing filler. The first layer 31 having the function of trapping moisture is also referred to as a getter layer.

The resin constituting the first layer 31 may be any resin that has low water vapor and oxygen permeability and good adhesion to the cell 3, and an example of a suitable resin is an olefin-based polymer. An olefin-based polymer is a polymer whose main constituent units are units derived from olefin. The first layer 31 is, for example, a layer of an olefin-based polymer having a moisture-absorbing filler dispersed therein. The first layer 31 may contain components other than the olefin-based polymer and the moisture-absorbing filler. Examples of such other components include a tackifier, a curing accelerator, an antioxidant, a plasticizer, and a rubber component.

The olefin-based polymer is preferably a copolymer of two or more kinds of olefins, or a copolymer of an olefin and a monomer other than an olefin such as a non-conjugated diene or styrene. Examples of the copolymer include ethylene-non-conjugated diene copolymer, ethylene-propylene copolymer, ethylene-propylene-non-conjugated diene copolymer, ethylene-butene copolymer, propylene-butene copolymer, propylene-butene-non-conjugated diene copolymer, styrene-isobutene copolymer, styrene-isobutene-styrene copolymer, and isobutene-isoprene copolymer.

The olefin-based polymer preferably has a cross-linked structure, and is obtained by reacting a copolymer containing a first reactive functional group with a copolymer containing a second reactive functional group. The reactive functional groups can be selected from the group consisting of an epoxy group, a carboxy group, an acid anhydride group, an amino group, a hydroxyl group, and an isocyanate group, and are used in a mutually reactive combination. Specific examples of the combination of the reactive functional groups include an epoxy group and a carboxy group, an epoxy group and an acid anhydride group, and a carboxy group and an acid anhydride group.

Examples of the moisture-absorbing filler include uncalcined hydrotalcite, semi-calcined hydrotalcite, calcined hydrotalcite, calcium oxide, magnesium oxide, calcined dolomite, calcium hydride, strontium oxide, aluminum oxide, barium oxide, molecular sieves, and silica.

The thickness of the first layer 31 is, for example, greater than or equal to 10 µm and less than or equal to 100 µm, and preferably greater than or equal to 30 µm and less than or equal to 70 µm. When the thickness of the first layer 31 is within this range, it is possible to achieve good sealing performance and good performance of trapping water vapor and the like. During a manufacturing process of the solar cell module 1, the material for constituting the first layer 31 is supplied in the form of a film, and is heated, pressurized, or pressurized while being heated, so that the material flows to be closely adhered to the cell without any gaps and also filled in the grooves of the cells 3.

The second layer 32 is a layer having low water vapor and oxygen permeability, and is provided covering the entire first layer 31 to thereby suppress inflow of water vapor and oxygen into the module. The second layer 32 is preferably composed of a resin film having a barrier layer. The resin film is, for example, mainly composed of a resin, such as an olefin polymer such as polyethylene, polypropylene, or polyvinyl chloride, a polyester such as polyethylene terephthalate, a polycarbonate, or a polyimide. The barrier layer is preferably formed on the inner surface of the resin film; that is, on the surface facing the first layer 31. Examples of the barrier layer include inorganic films such as a vapor-deposited silica film, a silicon nitride film, and a silicon oxide film.

The thickness of the second layer 32 is, for example, greater than or equal to 20 µm and less than or equal to 150 µm, and preferably greater than or equal to 50 µm and less than or equal to 100 µm. Since the barrier layer is thinner than the resin film, the thickness of the second layer 32 is substantially the same as the thickness of the resin film constituting the second layer 32. No particular limitation is imposed on the relationship between the thicknesses of the first layer 31 and the second layer 32.

As described above, the first layer 31 and the second layer 32 are laminated in this order from the substrate 2 side, and are positioned such that the first opening 31A and the second opening 32A are overlapped. Although a part of the surface 21 of the extraction electrode layer 20 is exposed through the opening 30A (i.e., the first opening 31A and the second opening 32A) of the sealing layer 30, the surface 21 is located toward the substrate 2 from the surface of the sealing layer 30, and is embedded in the sealing layer 30. In the present embodiment, the surface 21 of the extraction electrode layer 20 is located toward the substrate 2 from the interface between the first layer 31 and the second layer 32.

It is preferable that the first layer 31 covers the peripheral portion of the surface 21 of the extraction electrode layer 20 and is closely adhered to the side surfaces of the extraction electrode layer 20 along the thickness direction. In that case, inflow of water vapor and oxygen into the module is more effectively suppressed. In the present embodiment, the first opening 31A of the first layer 31 is formed to be smaller than the second opening 32A of the second layer 32. The opening 30A of the sealing layer 30 formed by the first opening 31A and the second opening 32A may be tapered toward the surface 21 of the extraction electrode layer 20. In the example shown in FIG. 1, the first opening 31A gradually narrows in diameter toward the surface 21.

The first layer 31 preferably covers the entire peripheral portion of the surface 21. That is, the first layer 31 is closely adhered to the surface 21 along the entire perimeter of the peripheral portion of the surface 21 so as to enclose the part of the surface 21 exposed through the first opening 31A. In that state, suppression of water vapor and oxygen inflow becomes more notable. The first layer 31 may be provided along the entire perimeter at a substantially uniform width from the peripheral edge of the surface 21. The first layer 31 covers, for example, an area greater than or equal to 10% and less than or equal to 50% of the area of the surface 21. In the present embodiment, the second opening 32A of the second layer 32 is formed to have a size larger than or equal to that of the surface 21.

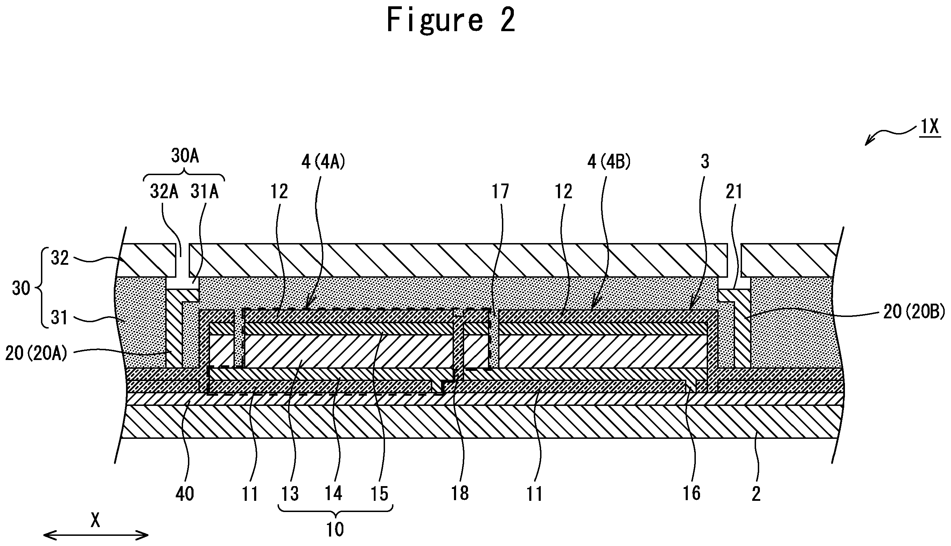

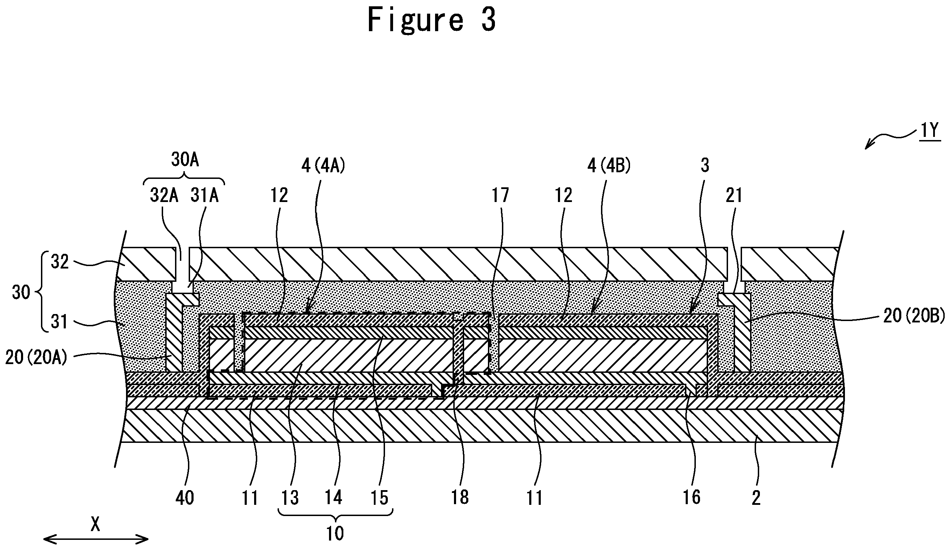

FIG. 2 is a cross-sectional view of a solar cell module 1X according to a second embodiment, and FIG. 3 is a cross-sectional view of a solar cell module 1Y according to a third embodiment.

As shown in FIGS. 2 and 3, the solar cell modules 1X, 1Y have the features in common with the solar cell module 1 that the sealing layer 30 has a two-layer structure including the first layer 31 and the second layer 32, and that the surface 21 of the extraction electrode layer 20 is located toward the substrate 2 from the interface between the first layer 31 and the second layer 32. That is, the extraction electrode layer 20 is in an embedded state in the first layer 31. In this case as well, when the substrate 2 is observed in plan view from the side on which the photoelectric conversion layer 10 is provided, a part of the surface 21 of the extraction electrode layer 20 is exposed through the first opening 31A and the second opening 32A.

Meanwhile, the solar cell modules 1X, 1Y differ from the solar cell module 1 in that the second opening 32A of the second layer 32 is formed to be smaller than the first opening 31A of the first layer 31. In other words, the first opening 31A is wider than the second opening 32A. In this case, the opening area at the outermost surface of the solar cell module 1 is decreased, so that the amount of water vapor and oxygen flowing into the opening can be reduced.

In the solar cell module 1X shown in FIG. 2, the second opening 32A of the second layer 32 is formed to be smaller in area othan the surface 21 of the extracting electrode layer 20. Furthermore, the second layer 32 is located over the peripheral portion of the surface 21 so as to cover the peripheral portion along its entire perimeter. Here, since the first layer 31 is interposed between the extraction electrode layer 20 and the second layer 32, the second layer 32 is not in contact with the surface 21. The opening area of the second opening 32A is preferably made small within the range that does not obstruct extraction of electric power from the extraction electrode layer 20, and is, for example, less than or equal to 90% of the area of the surface 21. In the solar cell module 1X, the first opening 31A of the first layer 31 is formed to have a size larger than or equal to that of the surface 21, and the peripheral portion of the surface 21 is not covered by the first layer 31.

As with the solar cell module 1X, in the solar cell module 1Y shown in FIG. 3, the second opening 32A of the second layer 32 is formed to be smaller in area than the surface 21 of the extraction electrode layer 20, and the second layer 32 is located over the peripheral portion of the surface 21. The solar cell module 1Y differs from the solar cell module 1X in that the first opening 31A of the first layer 31 is formed to be smaller in area than the surface 21, and in that the peripheral portion of the surface 21 is covered by the first layer 31. That is, the sizes are such that "surface 21 > first opening 31A > second opening 32A", and the peripheral portion of the surface 21 is covered by the first layer 31 and the second layer 32. In this case, suppression of water vapor and oxygen inflow becomes more notable.

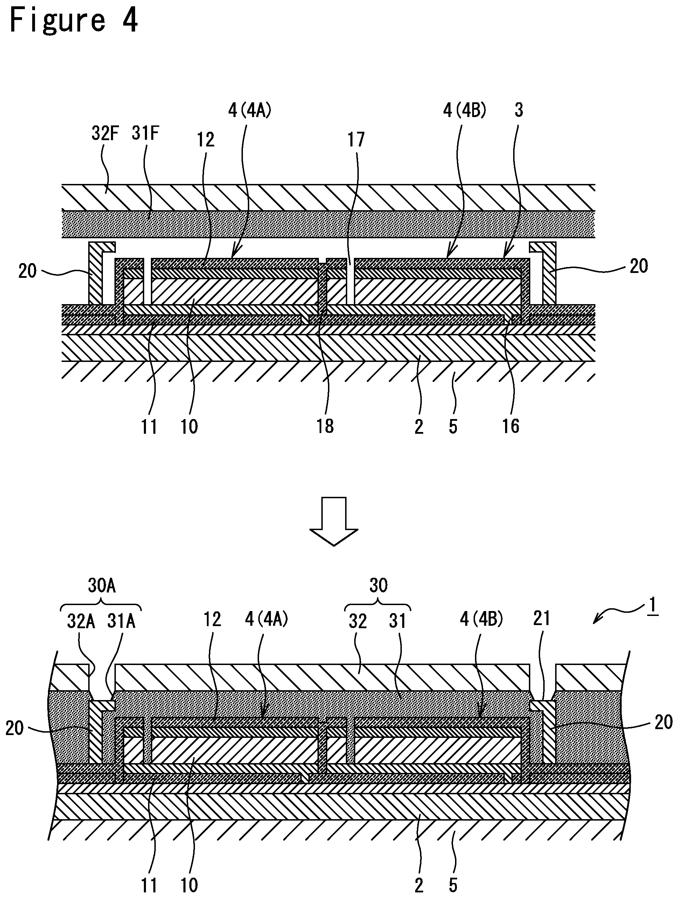

An example method for manufacturing the solar cell modules 1, 1X, 1Y having the above-described configurations will now be described in detail by reference to FIGS. 4 to 6. FIGS. 4 to 6 show the structures of cross sections obtained when a solar cell module is cut in the X direction during the manufacturing process.

The manufacturing process of the solar cell modules 1, 1X, 1Y includes, for example, the following steps:
(1) A step of providing a first electrode layer 11, a photoelectric conversion layer 10, and a second electrode layer 12 in this order on a substrate 2;
(2) A step of providing an extraction electrode layer 20 on the substrate 2 in a region that does not overlap with the photoelectric conversion layer 10 when the substrate 2 is observed in plan view; and
(3) A step of providing a sealing layer 30 on the second electrode layer 12 and the extraction electrode layer 20.

As noted above, the photoelectric conversion layer 10, the first electrode layer 11, the second electrode layer 12, and the extraction electrode layer 20 can be provided on the substrate 2 by a conventionally known method.

FIGS. 4 to 6 are diagrams showing the step of providing the sealing layer 30, and each of the diagrams illustrates a different formation method. In the examples shown in FIGS. 4 to 6, a support member 5 that supports the substrate 2 is used. As the support member 5, a material having a thickness and rigidity greater than those of the substrate 2 is used. For example, in a state of being placed on the support member 5, the solar cell module is transported, and the respective layers are formed on the substrate 2. Use of the support member 5 enables stable mass production of solar cell modules. An adhesive layer for bonding may be provided between the support member 5 and the substrate 2.

FIG. 4 shows the manufacturing process of the solar cell module 1. In the example shown in FIG. 4, after the sealing layer 30 is provided on the second electrode layer 12 and the extraction electrode layer 20, a part of the sealing layer 30 is removed to form the opening 30A. Using a conventionally known scribing method or the like, the opening 30A is formed in the sealing layer 30 in a region corresponding to the extraction electrode layer 20; that is, at a position overlapping with the extraction electrode layer 20 in the thickness direction of the module. The opening 30A is formed such that, when the substrate 2 is observed in plan view from the side on which the photoelectric conversion layer 10 is provided, the extraction electrode layer 20 is exposed through the opening 30A, and the peripheral portion of the extraction electrode layer 20 is covered by the sealing layer 30.

In the example shown in FIG. 4, a film 31F for constituting the first layer 31 is placed so as to cover the second electrode layer 12 and the extraction electrode layer 20, and a film 32F for constituting the second layer 32 is placed further on top. The films 31F, 32F may be formed into one unit in advance and then supplied onto the substrate 2. The film 31F placed on the substrate 2 is heated, pressurized, or pressurized while being heated, and the film 31F is thereby caused to closely adhere to the cell 3 and the like. At that time, the groove 17 is also filled with the material constituting the first layer 31.

In the example shown in FIG. 4, the opening 30A of the sealing layer 30 (i.e., the first opening 31A of the first layer 31) is formed such that the opening area gradually decreases toward the surface 21 of the extraction electrode layer 20. While the first layer 31 covers the peripheral portion of the surface 21 along the entire perimeter, openings may be formed in the films 31F, 32F such that both the first layer 31 and the second layer 32 cover the peripheral portion of the surface 21. That is, both the first opening 31A and the second opening 32A may be formed to be smaller in area than the surface 21.

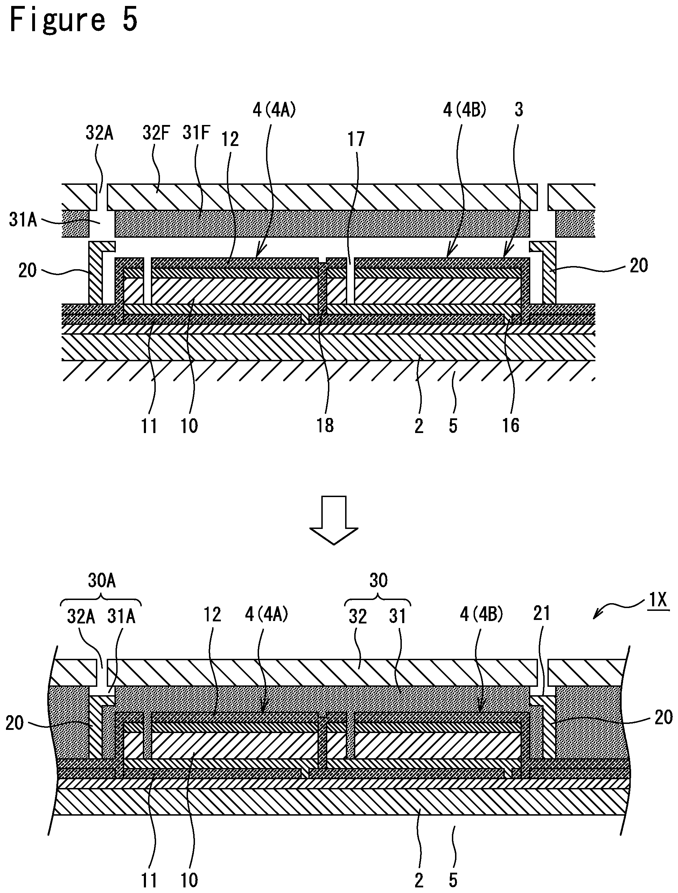

FIG. 5 shows the manufacturing process of the solar cell module 1X. In the example shown in FIG. 5, the sealing layer 30 with the opening 30A is arranged onto the second electrode layer 12 and the extraction electrode layer 20. In this case, the sealing layer 30 is arranged such that, when the substrate 2 is observed in plan view from the side on which the photoelectric conversion layer 10 is provided, the extraction electrode layer 20 is exposed through the opening 30A, and the peripheral portion of the extraction electrode layer 20 is covered. That is, in this manufacturing process, films 31F, 32F having openings formed therein in advance are placed on the substrate 2. More specifically, the films 31F, 32F are placed such that the extraction electrode layer 20, the first opening 31A, and the second opening 32A are overlapped in the thickness direction of the module.

While FIG. 5 shows the manufacturing process of the solar cell module 1X, a similar method can be used to manufacture the solar cell modules 1, 1Y. In the example shown in FIG. 5, the second opening 32A of the second layer 32 is formed to be smaller than the first opening 31A of the first layer 31, and the sizes are such that "surface 21 of the extraction electrode layer 20 ≥ first opening 31A > second opening 32A". However, by changing the sizes of the openings, the solar cell modules 1, 1Y can be manufactured.

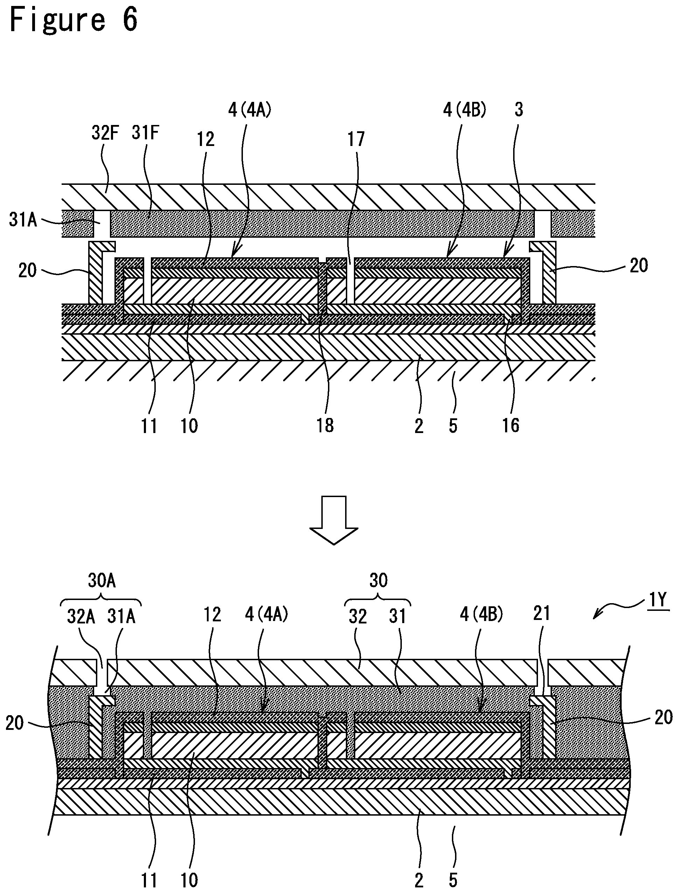

While FIG. 6 shows the manufacturing process of the solar cell module 1Y, a similar method can be used to manufacture the solar cell module 1X. In the example shown in FIG. 6, the first layer 31 having the first opening 31A formed therein in advance is arranged onto the second electrode layer 12 and the extraction electrode layer 20, and after providing the second layer 32 on the first layer 31, the second opening 32A is formed. That is, this manufacturing process includes a step of providing a first layer 31 having a first opening 31A in a region corresponding to the extraction electrode layer 20, a step of providing a second layer 32 on the first layer 31, and a step of removing a part of the second layer 32 to form a second opening 32A.

In the example shown in FIG. 6, the first layer 31 and the second layer 32 are provided and the second opening 32A is formed such that, when the substrate 2 is observed in plan view from the side on which the photoelectric conversion layer 10 is provided, the extraction electrode layer 20 is exposed through the first opening 31A and the second opening 32A, and the peripheral portion of the extraction electrode layer 20 is covered by at least one of the first layer 31 and the second layer 32. In this manufacturing process, a film 31F is placed such that the extraction electrode layer 20 and the first opening 31A overlap in the thickness direction of the module, and after laminating a film 32F on the film 31F, the second opening 32A is formed at a position overlapping with the first opening 31A.

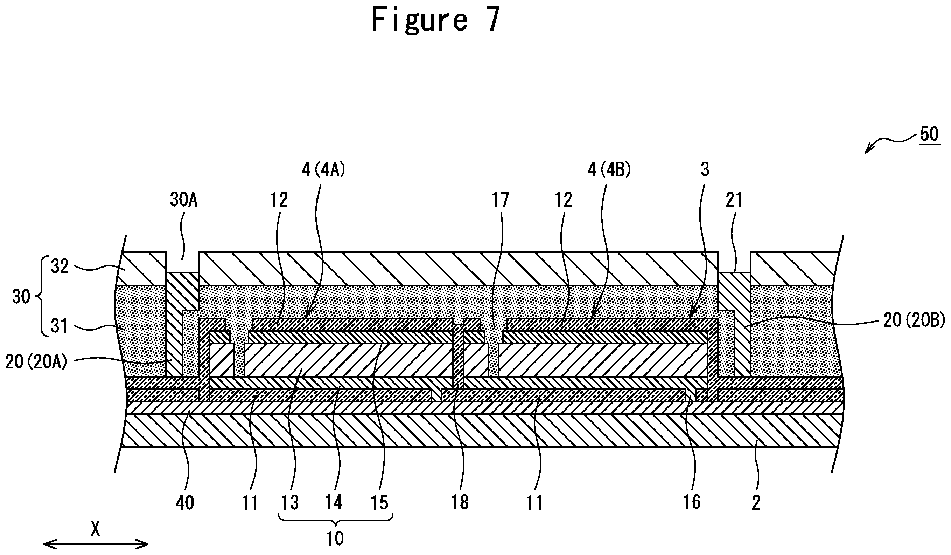

Other embodiments of the solar cell module will next be described by reference to FIGS. 7 to 10. In the following, differences from the above embodiments are described.

As in the above embodiments, in fourth to sixth embodiments shown as examples in FIGS. 7 to 9, the surface 21 of the extraction electrode layer 20 is located toward the substrate 2 from the surface of the sealing layer 30, and is embedded in the sealing layer 30. Further, the surface 21 of the extraction electrode layer 20 is exposed through the opening 30A of the sealing layer 30. Meanwhile, the surface 21 of the extraction electrode layer 20 is not covered by the first layer 31 or the second layer 32. However, the features of the first to third embodiments can be selectively applied to the fourth to sixth embodiments. In that case, suppression of water vapor and oxygen inflow becomes more notable.

As shown in FIG. 7, in a solar cell module 50 according to the fourth embodiment, the groove 17 filled with the first layer 31 of the sealing layer 30 is formed such that its width gradually increases with increasing distance from the substrate 2. The groove 17 is formed, for example, by removing a part of each of the photoelectric conversion layer 10, the hole transport layer 15, and the second electrode layer 12 (i.e., parts that overlap in the thickness direction of the module). Here, the opening formed in the hole transport layer 15 is created larger than the opening formed in the photoelectric conversion layer 10. Further, the opening in the second electrode layer 12 is created larger than the opening in the hole transport layer 15.

As noted above, the solar cell module 50 has formed therein the groove 17 having a width that gradually increases with increasing distance from the substrate 2, and the first layer 31 is formed inside the groove 17. As shown in FIG. 7, the width of the groove 17 may vary stepwise at the interfaces between layers, or the width may increase continuously from the photoelectric conversion layer 10 toward the second electrode layer 12. By providing such a groove 17, the material constituting the first layer 31 can be easily filled into the groove, and voids are less likely to be created inside the groove. As a result, inflow of water vapor and oxygen into the module is effectively suppressed.

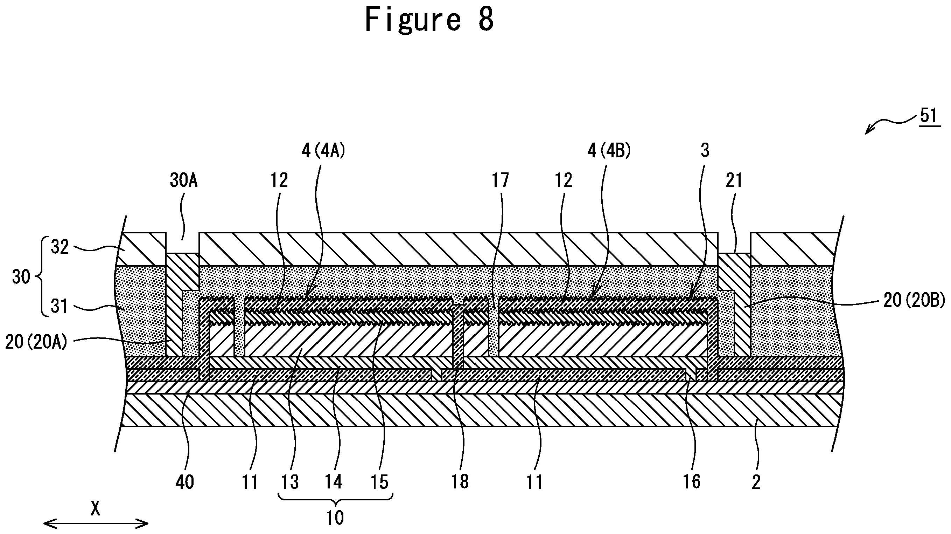

As shown in FIG. 8, in a solar cell module 51 according to the fifth embodiment, fine unevenness is formed at the surface of the second electrode layer 12 in contact with the first layer 31 of the sealing layer 30. In this case, the contact area between the first layer 31 and the second electrode layer 12 is increased, and adhesion between the first layer 31 and the second electrode layer 12 is improved. As a result, voids are less likely to occur between the first layer 31 and the second electrode layer 12, and inflow of water vapor and oxygen into the module is effectively suppressed. Although it may be the case that unevenness is formed only at the surface of the second electrode layer 12, in the example shown in FIG. 8, unevenness is formed at the surface of the photoelectric conversion layer 10, and by depositing the hole transport layer 15 and the second electrode layer 12 along the unevenness of the photoelectric conversion layer 10, unevenness is formed at the surface of the second electrode layer 12.

The arithmetic mean roughness Ra of the surface of the second electrode layer 12 is, for example, greater than or equal to 1 nm and less than or equal to 100 nm. When the arithmetic mean roughness Ra is within this range, improvement in adhesion between the first layer 31 and the second electrode layer 12 becomes more notable. The arithmetic mean roughness Ra of the surface of the second electrode layer 12 can be measured by cross-sectional TEM. No particular limitation is imposed on the method for forming the unevenness at the surface of the photoelectric conversion layer 10, and one example is a spin coating method.

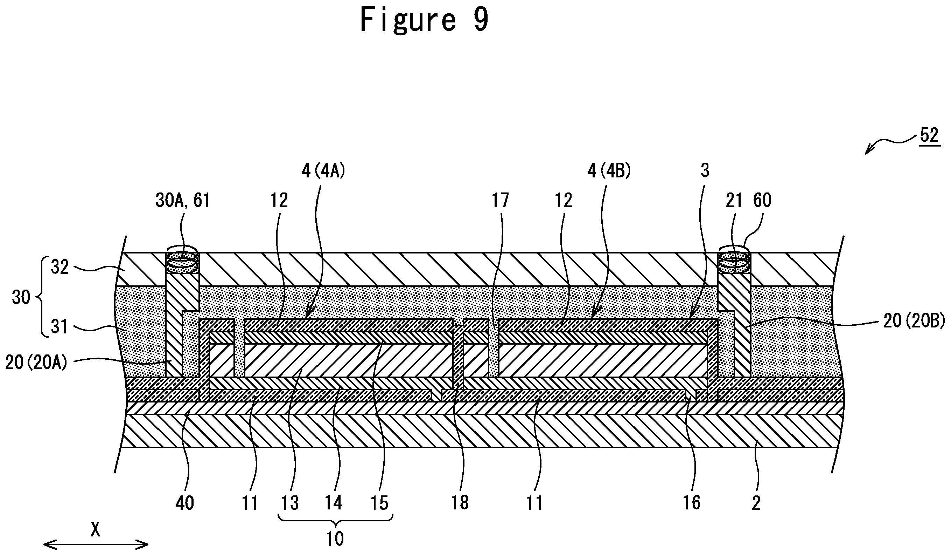

As shown in FIG. 9, a solar cell module 52 according to the sixth embodiment includes a spring electrode 60 as a wiring member electrically connected to the extraction electrode layer 20. The spring electrode 60 is arranged within the opening 30A of the sealing layer 30, and one axial end thereof is in contact with the surface 21 of the extraction electrode layer 20. The other axial end of the spring electrode 60 protrudes from the opening 30A, and is connected to an external device (not shown in drawing). The opening 30A may be filled with a sealant 61 that seals the gap between the sealing layer 30 and the spring electrode 60. As the sealant 61, it is possible to use, for example, the same material as the constituent material of the first layer 31.

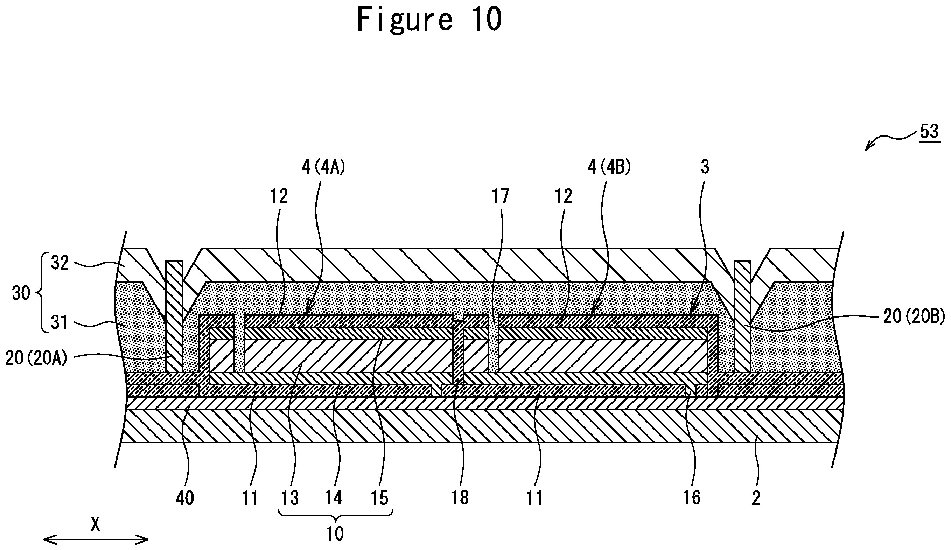

As shown in FIG. 10, in a solar cell module 53 according to a seventh embodiment, the thickness of the first layer 31 constituting the sealing layer 30 is reduced around the extraction electrode layer 20. The extraction electrode layer 20 is formed to be thicker than the sealing layer 30, and an opening in the film for constituting the first layer 31 is made large enough to provide a gap between the film and the extraction electrode layer 20, so that the film fills the gap and sinks toward the substrate 2. Furthermore, in the part around the extraction electrode layer 20, the second layer 32 conforms to the first layer 31, and the surface of the second layer 32 becomes recessed. Accordingly, the surface 21 of the extraction electrode layer 20 and its vicinity protrude from the sealing layer 30.

According to the solar cell module 53, the sealing layer 30 is tightly adhered to the side surface of the extraction electrode layer 20, and gaps are unlikely to be formed between the extraction electrode layer 20 and the sealing layer 30. As a result, inflow of water vapor and oxygen into the module is effectively suppressed.

As described above, according to the solar cell modules of the above embodiments, inflow of water vapor and oxygen into the modules can be sufficiently suppressed. The solar cell modules of the above embodiments have excellent sealing performance, and therefore can maintain good output performance for a long period of time. Particularly in the case where, as in the solar cell modules 1, 1X, 1Y of the first to third embodiments, the peripheral portion of the extraction electrode layer 20 is covered with the sealing layer 30 when the substrate 2 is observed in plan view from the side on which the photoelectric conversion layer 10 is provided, inflow of water vapor and oxygen into the module from around the extraction electrode layer 20 is effectively suppressed.

The above embodiments can be modified in design as appropriate within a range in which the objects of the present disclosure are not impaired. As noted above, the features of the first to third embodiments can be selectively applied to the fourth to sixth embodiments, and in that case, suppression of water vapor and oxygen inflow becomes more notable. In other words, at least one feature selected from the group consisting of the widening shape of the groove 17 in the fourth embodiment, the surface unevenness of the second electrode layer 12 in the fifth embodiment, and the spring electrode 60 in the sixth embodiment may be applied to the solar cell modules 1, 1X, and 1Y.

The sealing layer may be supplied to the manufacturing process of the solar cell module in the form of a single film including the above-described barrier layer as an intermediate layer. The barrier layer is, for example, sandwiched between two resin films. As the resin film to be arranged on the substrate 2, it is possible to use a film having functions similar to those of the above-described film for constituting the first layer 31, and as the resin film to be arranged on the outer side of the barrier layer, it is possible to use a film having functions similar to those of the above-described film for constituting the second layer 32.

### REFERENCE SIGNS LIST

1, 1X, 1Y, 50, 51, 52, 53 solar cell module; 2 substrate; 3 cell; 4, 4A, 4B unit cell; 5 support member; 10 photoelectric conversion layer; 11 first electrode layer; 12 second electrode layer; 13 light-absorbing layer; 14 electron transport layer; 15 hole transport layer; 16, 17, 18 groove; 20, 21, 20B extraction electrode layer; 21 surface; 30 sealing layer; 30A opening; 31 first layer; 31A first opening; 32 second layer; 32A second opening; 40 inorganic film; 60 spring electrode; 61 sealant

## Claims

1. A solar cell module, comprising:
a substrate;
a first electrode layer provided on the substrate;
a photoelectric conversion layer provided on the first electrode layer;
a second electrode layer provided on the photoelectric conversion layer;
an extraction electrode layer provided on the substrate in a region that does not overlap with the photoelectric conversion layer when the substrate is observed in plan view; and
a sealing layer which is provided so as to cover the first electrode layer, the photoelectric conversion layer, the second electrode layer, and the extraction electrode layer, and which has an opening in a region corresponding to the extraction electrode layer, wherein
when the substrate is observed in plan view from a side on which the photoelectric conversion layer is provided, the extraction electrode layer is exposed through the opening, and a peripheral portion of the extraction electrode layer is covered by the sealing layer.

2. The solar cell module according to claim 1, wherein
the sealing layer includes a first layer having a first opening in a region corresponding to the extraction electrode layer, and a second layer provided so as to cover the first layer and having a second opening in a region corresponding to the extraction electrode layer,
when the substrate is observed in plan view from the side on which the photoelectric conversion layer is provided, the extraction electrode layer is exposed through the first opening and the second opening, and
the second opening is formed to be smaller than the first opening.

3. The solar cell module according to claim 2, wherein
when the substrate is observed in plan view from the side on which the photoelectric conversion layer is provided, the peripheral portion of the extraction electrode layer is covered by the first layer and the second layer.

4. The solar cell module according to any one of claims 1 to 3, wherein
the photoelectric conversion layer comprises a light-absorbing layer, an electron transport layer, and a hole transport layer, and
the light-absorbing layer contains a perovskite compound.

5. A solar cell module manufacturing method, comprising:
a step of providing a first electrode layer, a photoelectric conversion layer, and a second electrode layer in this order on a substrate;
a step of providing an extraction electrode layer on the substrate in a region that does not overlap with the photoelectric conversion layer when the substrate is observed in plan view; and
a step of providing a sealing layer with an opening on the second electrode layer and the extraction electrode layer, wherein
the sealing layer is provided such that, when the substrate is observed in plan view from a side on which the photoelectric conversion layer is provided, the extraction electrode layer is exposed through the opening, and a peripheral portion of the extraction electrode layer is covered by the sealing layer.

6. A solar cell module manufacturing method, comprising:
a step of providing a first electrode layer, a photoelectric conversion layer, and a second electrode layer in this order on a substrate;
a step of providing an extraction electrode layer on the substrate in a region that does not overlap with the photoelectric conversion layer when the substrate is observed in plan view;
a step of providing a sealing layer on the second electrode layer and the extraction electrode layer; and
a step of removing a part of the sealing layer to form an opening, wherein
the opening is formed in the sealing layer such that, when the substrate is observed in plan view from a side on which the photoelectric conversion layer is provided, the extraction electrode layer is exposed through the opening, and a peripheral portion of the extraction electrode layer is covered by the sealing layer.

7. A solar cell module manufacturing method, comprising:
a step of providing a first electrode layer, a photoelectric conversion layer, and a second electrode layer in this order on a substrate;
a step of providing an extraction electrode layer on the substrate in a region that does not overlap with the photoelectric conversion layer when the substrate is observed in plan view;
a step of providing a first sealing layer on the second electrode layer and the extraction electrode layer, the first sealing layer having a first opening in a region corresponding to the extraction electrode layer;
a step of providing a second sealing layer on the first sealing layer; and
a step of removing a part of the second sealing layer to form a second opening, wherein
the first layer and the second layer are provided and the second opening is formed such that, when the substrate is observed in plan view from a side on which the photoelectric conversion layer is provided, the extraction electrode layer is exposed through the first opening and the second opening, and a peripheral portion of the extraction electrode layer is covered by at least one of the first layer and the second layer.
